# EUROPEAN PATENT APPLICATION

(11) **EP 2 479 808 A1**
(43) Date of publication of application: **25.07.2012**
(21) Application number: 10817342.8
(22) Date of filing: 07.06.2010
(51) Int. Cl.: H01L 33/42, H01L 33/14

(54) **SEMICONDUCTOR LIGHT-EMITTING DEVICE**

(30) Priority: 17.09.2009 KR 20090088009
(71) Applicant: Quantum Device Inc., Hwaseong-Si Gyeonggi-do (KR)
(72) Inventor: LEE, Hae-Gwon, Yongin-si Gyeonggi-do (KR)
(74) Representative: Walaski, Jan Filip
(86) International application number: PCT/KR2010/003641
(87) International publication number: WO 2011/034273

(57) **Abstract**

Disclosed is a semiconductor light emitting device including: a substrate; an n-type semiconductor layer giving an electron when receiving voltage; a p-type semiconductor layer giving a hole when receiving voltage; an active layer provided between the n-type semiconductor layer and the p-type semiconductor layer and including a quantum well structure to facilitate coupling between an electron and a hole; an n-type electrode including conductivity for applying voltage to the n-type semiconductor layer; a p-type electrode including conductivity for applying voltage to the p-type semiconductor layer; and am electric-current diffusion and hole injection layer provided between the p-type semiconductor layer and the p-type electrode and doped with n-type impurities and p-type impurities for diffusing an electric current and injecting a hole between the p-type electrode and the p-type semiconductor layer.

With this, ohmic contact is decreased, flow of an electric current is improved, diffusion of the electric current is more uniformized, and injection of a hole is improved between the electrode and the semiconductor layer of the semiconductor light emitting device, thereby maximizing efficiency of a device.

## Description

### TECHNICAL FIELD

Apparatuses and methods consistent with the exemplary embodiments relate to a semiconductor light emitting device, and more particularly to a semiconductor light emitting device capable of enhancing diffusion of a current and injection of holes between an electrode and a semiconductor layer.

### BACKGROUND

A semiconductor light emitting device, used in various fields such as a liquid crystal display (LCD) backlight, illumination, a display, etc. and widely known as a "light emitting diode (LED)," emits light on the principle that the light is emitted having a wavelength range corresponding to an energy gap between a conduction band and a valence band when a forward bias voltage is applied to a p-n junction semiconductor.

Such a semiconductor light emitting device is required to be improved in various design indexes such as quantum efficiency, photon extraction efficiency, packaging, reliance, etc. Among such indexes, diffusion of an electric current and injection of holes between an electrode and a semiconductor layer are particularly important in light of design.

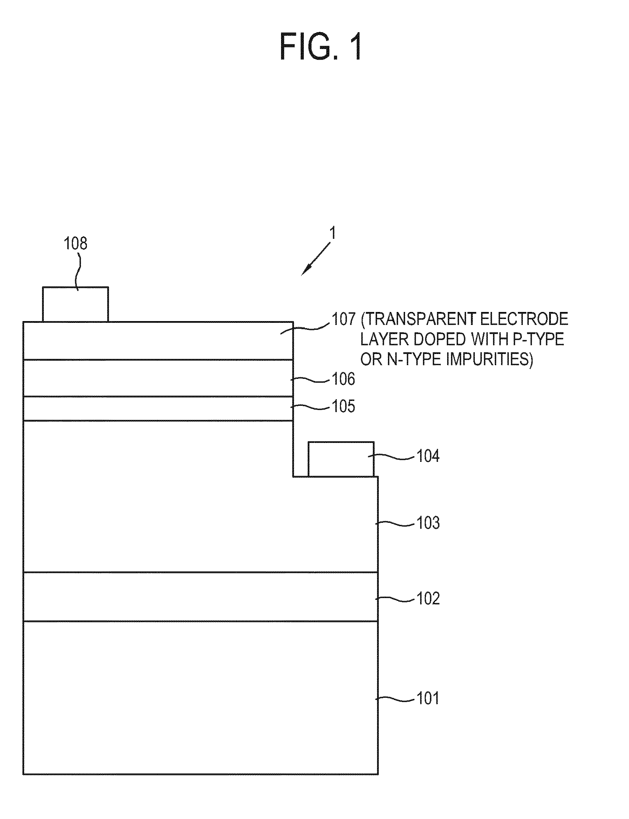

FIG. 1 shows a cross section of a conventional semiconductor light emitting device. In the conventional semiconductor light emitting device 1, a buffer layer 102 is provided on a substrate 101, an n-type semiconductor layer 103 is provided on the buffer layer 102, and an active layer 105 and a p-type semiconductor layer 106 are provided on the n-type semiconductor layer 103. Also, the semiconductor light emitting device 1 further includes an n-type electrode 104 and a p-type electrode 108 to apply voltages to the n-type semiconductor layer 103 and the p-type semiconductor layer 106, respectively.

The semiconductor light emitting device 1 additionally includes a transparent electrode 107 between the p-type electrode 108 and the p-type semiconductor layer 106. The transparent electrode 107 is a transparent or translucent layer having conductivity, which can be achieved by a ZnO based compound to which p-type or n-type impurities are added. Specifically, the transparent electrode 107 was doped with the n-type impurities to enhance the diffusion of an electric current, but the p-type impurities to enhance the injection of holes. Thus, the transparent electrode 107 was doped with either of the n-type impurities or the p-type impurities, so that the diffusion of an electric current or the injection of holes can be enhanced to thereby improve an ohmic contact characteristic of a device.

That is, the conventional transparent electrode 107 is doped with either of the n-type impurities or the p-type impurities. For example, as shown in FIG. 1, there has been used a method of doping the transparent electrode 107 contacting the p-type semiconductor layer 106 with the p-type impurities for injecting the holes.

However, the conventional transparent electrode 107 doped with either of the n-type impurities or the p-type impurities could improve one of the diffusion of an electric current or the injection of holes but could not be expected to improve both of them. For example, in the case that the transparent electrode 107 is formed using ZnO on a GaN-based semiconductor layer, if the transparent electrode 107 is doped with only the p-type impurities, the injection of holes is enhanced to some extent by increasing hole concentration but it is difficult to improve the flow and diffusion of an electric current.

### DETAILED DESCRIPTION

### TECHNICAL PROBLEMS

Accordingly, one or more exemplary embodiments provide a semiconductor light emitting device which can improve flow of an electric current between an electrode and a semiconductor layer, uniformize diffusion thereof, and enhance injection of holes, thereby maximizing efficiency.

### SUMMARY OF INVENTION

The foregoing and/or other aspects may be achieved by providing a semiconductor light emitting device including: a substrate; an n-type semiconductor layer giving an electron when receiving voltage; a p-type semiconductor layer giving a hole when receiving voltage; an active layer provided between the n-type semiconductor layer and the p-type semiconductor layer and including a quantum well structure to facilitate coupling between an electron and a hole; an n-type electrode including conductivity for applying voltage to the n-type semiconductor layer; a p-type electrode including conductivity for applying voltage to the p-type semiconductor layer; and am electric-current diffusion and hole injection layer provided between the p-type semiconductor layer and the p-type electrode and doped with n-type impurities and p-type impurities for diffusing an electric current and injecting a hole between the p-type electrode and the p-type semiconductor layer.

The electric-current diffusion and hole injection layer may transmit at least a part of light due to coupling between an electron and a hole.

The electric-current diffusion and hole injection layer may include a compound of ZnO.

At least one of the n-type semiconductor layer and the p-type semiconductor layer may include a GaN-based compound.

The electric-current diffusion and hole injection layer may be formed by a molecular beam epitaxy (MBE) method.

The semiconductor light emitting device may further include a buffer layer between the substrate and the n-type semiconductor layer.

Another aspect may be achieved by providing a semiconductor light emitting device including: a substrate; an n-type semiconductor layer giving an electron when receiving voltage; a p-type semiconductor layer giving a hole when receiving voltage; an active layer provided between the n-type semiconductor layer and the p-type semiconductor layer and including a quantum well structure to facilitate coupling between an electron and a hole; an n-type electrode including conductivity for applying voltage to the n-type semiconductor layer; a p-type electrode including conductivity for applying voltage to the p-type semiconductor layer; and am electric-current diffusion and hole injection layer provided between the n-type electrode and the n-type semiconductor layer and doped with n-type impurities and p-type impurities for diffusing an electric current and injecting a hole between the n-type electrode and the n-type semiconductor layer.

### EFFECT OF THE INVENTION

As described above, there is provided a semiconductor light emitting device which can improve flow of an electric current between an electrode and a semiconductor layer, uniformize diffusion thereof, and enhance injection of holes, thereby maximizing efficiency.

### BRIEF DESCRIPTION OF THE DRAWINGS

FIG. 1 is a cross-section view showing a configuration of a conventional semiconductor light emitting device,
FIG. 2 is a cross-section view showing a configuration of a semiconductor light emitting device according to an exemplary embodiment,
FIG. 3 is a flowchart showing a manufacturing process of an electric-current diffusion and hole injection layer in the semiconductor light emitting device according to an exemplary embodiment, and
FIG. 4 is a view for explaining operations when an operating voltage is applied to a semiconductor light emitting device shown in FIG. 2.

### EXEMPLARY EMBODIMENTS

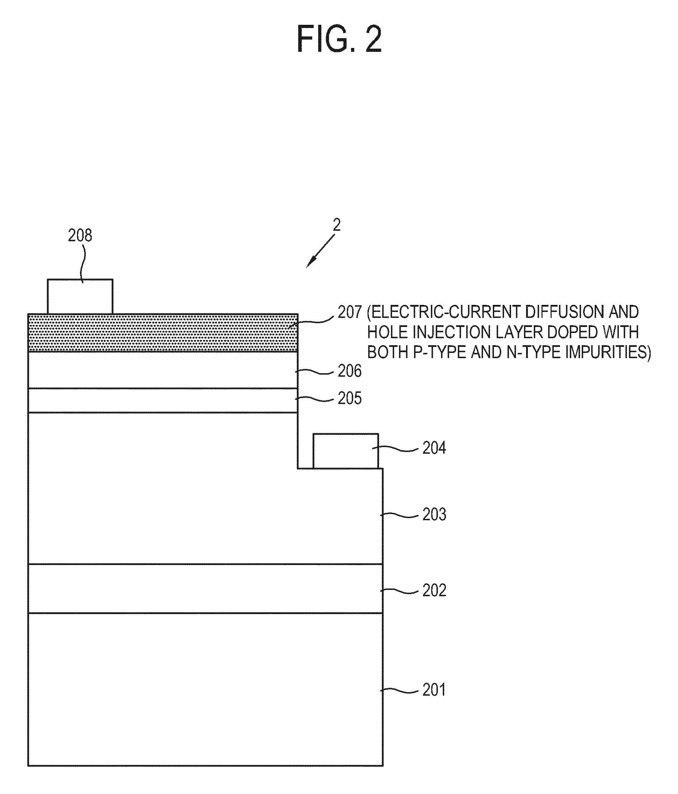

Below, exemplary embodiments will be described in detail with reference to accompanying drawings. FIG. 2 is a cross-section view showing a configuration of a semiconductor light emitting device according to an exemplary embodiment. For example, the semiconductor light emitting device 2 shown in FIG. 2 includes a light emitting device such as a light emitting diode (LED)."

As shown in FIG. 2, the semiconductor light emitting device 2 according to an exemplary embodiment may emit light when a forward bias voltage is applied to the semiconductor light emitting device 2. According to an exemplary embodiment, the semiconductor light emitting device 2 may emit light in various directions depending on its structure and use without any limitation.

Referring to FIG. 2, the semiconductor light emitting device 2 in this embodiment includes a substrate 201, a buffer layer 202, an n-type semiconductor layer 203, an active layer 205, a p-type semiconductor layer 206, an electric-current diffusion and hole injection layer 207, an n-type electrode 204 and a p-type electrode 205.

The substrate 201 in this embodiment is used for grow a semiconductor layer, which can be achieved by a material such as sapphire. Alternatively, the substrate according to another exemplary embodiment may be achieved by SiC, GaN, ZnO, etc. in consideration of a match with the semiconductor layer with regard to a lattice constant.

The buffer layer 202 in this embodiment is provided on the substrate 201. Here, the buffer layer 202 is used for minimizing a crystal defect due to a mismatch with the n-type semiconductor layer 203 with respect to the lattice constant and a thermal expansion coefficient.

The n-type semiconductor layer 203 in this embodiment is provided on the buffer layer 202. The n-type semiconductor layer 203 gives electrons when receiving a forward bias voltage. In this embodiment, the n-type semiconductor layer 203 may be formed by growing a compound semiconductor through a metal organic chemical vapor deposition (MOCVD) method. For example, in the case of a blue or ultraviolet (UV) LED, The n-type semiconductor layer 203 in this embodiment may be achieved by a GaN-based compound doped with n-type impurities. Here, the n-type impurities may be Si.

On the n-type semiconductor layer 203 in this embodiment may be formed the active layer 205. The active layer 205 has a structure of a quantum well, thereby more activating coupling between an electron of the n-type semiconductor layer 203 and a hole of the p-type semiconductor layer 206.

In this embodiment, a layer of InGaN may be grown as a well of the active layer 205, and a layer of (Al)GaN may be grown as a barrier layer. According to another exemplary embodiment, the blue LED may use a multiple quantum well structure of InGaN/GaN, and the UV LED may use a multiple quantum well structure of GaN/AlGaN, InAlGaN/InAlGaN, InGaN/AlGaN, etc. With this active layer 205, a wavelength of light can be adjusted by changing a composition ratio of In or Al, or quantum efficiency in the LED can be enhanced by changing the depth of the quantum well in the active layer 205, the number of active layers, the thickness of the active layer 205, etc. According to still another exemplary embodiment, an n-type or p-type AlGaN/GaN supperlattice may be inserted so as to increase carrier confinement above and below the active layer 205.

The p-type semiconductor layer 206 in this embodiment is formed on the active layer 205. The p-type semiconductor layer 206 gives a hole when receiving a forward bias voltage. The p-type semiconductor layer 206 is also formed by growing a compound semiconductor through the MOCVD method. For example, in the case of the blue or UV LED, the p-type semiconductor layer 206 in this embodiment may be achieved by a GaN-based compound doped with p-type impurities. Here, the p-type impurities may be Mg, Zn, etc.

On the p-type semiconductor layer 206 in this embodiment is formed the electric-current diffusion and hole injection layer 207. The electric-current diffusion and hole injection layer 207 is achieved by a conductive material capable of facilitating the diffusion of the electric current between the p-type electrode 208 and the p-type semiconductor layer 206. Also, the electric-current diffusion and hole injection layer 207 in this embodiment may be a transparent or translucent material capable of transmitting at least a part of light generated in the active layer 205 by coupling between the electron and the hole. For example, the electric-current diffusion and hole injection layer 207 may be ZnO.

According to this embodiment, the electric-current diffusion and hole injection layer 207 is doped with both the two n- and p-type impurities. In the electric-current diffusion and hole injection layer 207, the n-type impurities give the electrons, and the p-type impurities give the holes. Thus, the electric-current diffusion and hole injection layer 207 facilitates the diffusion of the electric current between the p-type electrode 208 and the p-type semiconductor layer 206. The n-type impurities doped in the electric-current diffusion and hole injection layer 207 may be a group 3 element such as Ga, and the p-type impurities may be a group 5 element such as As.

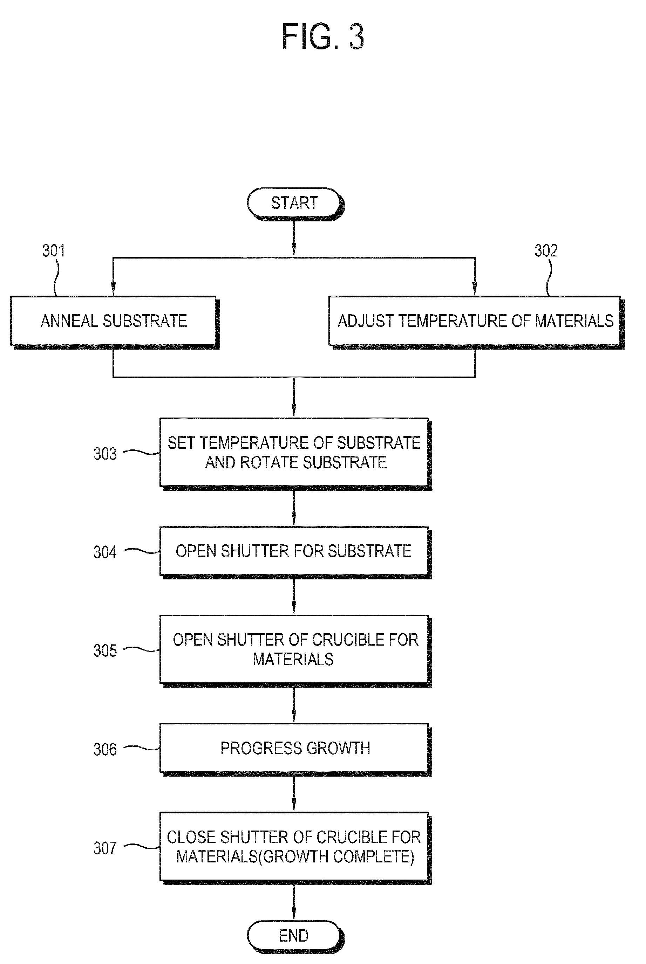

FIG. 3 is a flowchart showing a manufacturing process of an electric-current diffusion and hole injection layer 207 in the semiconductor light emitting device 2 according to an exemplary embodiment. In this embodiment, the manufacturing process of the electric-current diffusion and hole injection layer 207 can be achieved by a molecular beam epitaxy (MBE) method. Here, let the electric-current diffusion and hole injection layer 207 be a ZnO layer, and the n- and p-type impurities to be doped be the group 3 element such as Ga and the group 5 element such as As, respectively.

As shown in FIG. 3, the substrate 201 is first prepared as being heated up to a proper annealing temperature and cooled down to a predetermined growing temperature at operation 301. At the operation 301, the annealing temperature for the substrate 201 in this embodiment may be about 500 ∼ 700°C. Meanwhile, at operation 302 simultaneously with the operation 301, materials for the electric-current diffusion and hole injection layer 207 are also heated up and maintained at a proper temperature for the growth. In the operation 302, each temperature of the materials may be varied depending on processes, and also varied depending on growth degrees. Further, a temperature of a cell (or a crucible) in which each material is provided may be varied depending on the amount of materials put in the cell, the structure of the cell, etc.

For example, Zn may be maintained at a temperature of about 300 ∼ 600°C, Ga may be maintained at a temperature of about 500 ∼ 800°C, and As may be maintained at a temperature of about 200 ∼ 300°C. However, these temperatures disclosed in this embodiment are nothing but an example. In other words, these temperatures may be varied variously depending on use equipment or the like.

Under the condition prepared based on the operations 301 and 302, if the temperature of the substrate 201 is set, the substrate 201 is rotated at operation 303. Then, the shutter of the rotating substrate 201 and the shutter of the crucibles (or the cells) in which the respective materials are provided are opened at operations 304 and 305, so that molecules and atoms vaporized from each material can arrive at the substrate 201. In the operations 304 and 305, the molecules and the atoms of each material are popped out from the crucible and attached to the substrate 201 as the shutters of the substrate 201 and the respective crucibles are opened, thereby forming a thin film of the electric-current diffusion and hole injection layer 207 at operation 306.

In the operation 304 to 306, most of Zn is coupled with oxygen (O) and forms a single crystal of ZnO, and Ga is also coupled with oxygen and generates an electron. Since oxygen is most commonly found as molecular oxygen, a radio frequency (RF) plasma source device or the like may be used to separate the molecular oxygen and get atomic oxygen. Meanwhile, a hole is generated when Zn and As are coupled. Thus, both the electron and the hole exist within one thin film.

Then, when the electric-current diffusion and hole injection layer 207 is grown to some extent, the shutters of the crucibles for the respective materials are closed to thereby completing the growth of the electric-current diffusion and hole injection layer 207 at operation 307.

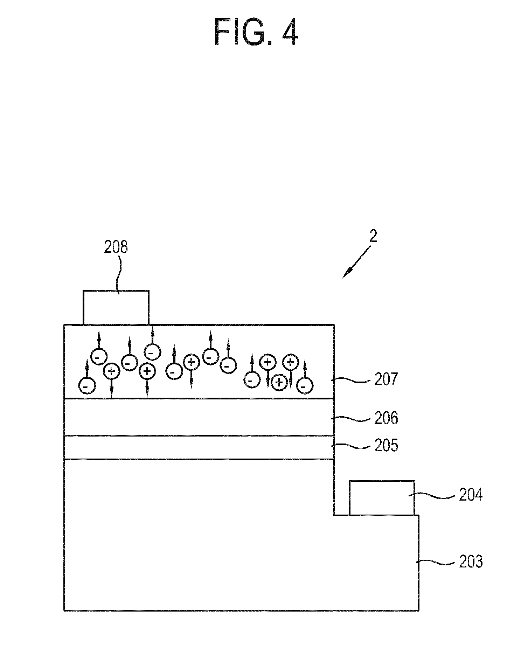

FIG. 4 is a view for explaining operations when an operating voltage is applied to a semiconductor light emitting device according to an exemplary embodiment. For convenience, the substrate 201 and the buffer layer 202 are not shown. According to this exemplary embodiment, the two n-and p-type impurities cause both the electrons (-) and the holes (+) to exist in the electric-current diffusion and hole injection layer 207. The electron (-) of the electric-current diffusion and hole injection layer 207 reduces ohmic contact between the p-type electrode 208 and the p-type semiconductor layer 206, thereby improving flow of an electric current and more uniformly diffusing the electric current. Further, the hole (+) of the electric-current diffusion and hole injection layer 207 assists the injection of the hole into the p-type semiconductor layer 206, thereby causing more electric current to flow more uniformly. Thus, in the semiconductor light emitting device 2 according to this embodiment, the operating voltage is lowered and emissive efficiency is enhanced, thereby maximizing the efficiency of the device.

In this embodiment, the n-type electrode 204 and the p-type electrode 205 apply voltages to the n-type semiconductor layer 203 and the p-type semiconductor layer 206. Here, the n-type electrode 204 is in contact with the n-type semiconductor layer 203, and the p-type electrode 205 is in contact with the electric-current diffusion and hole injection layer 207. After forming the electric-current diffusion and hole injection layer 207, the n-type electrode 204 may be formed on the n-type semiconductor layer 203 by partially etching the active layer 205, the p-type semiconductor layer 206 and the electric-current diffusion and hole injection layer 207. The n-type electrode 204 and the p-type electrode 205 may be achieved by a metallic material such as Ti, Au, Al, etc.

In this embodiment, the n-type electrode 204 is provided horizontally on the same side as the p-type electrode 205, but not limited thereto. Alternatively, the n-type electrode 204 may be provided vertically to be opposite to the p-type electrode 205 with respect to the active layer 205.

For instance, the foregoing embodiment discloses that the electric-current diffusion and hole injection layer 207 is provided corresponding to the p-type semiconductor layer 206, but it is nothing but an example. Alternatively, the electric-current diffusion and hole injection layer may be provided corresponding to the n-type semiconductor layer.

Also, alternatively, the semiconductor light emitting device may not include the buffer layer 202 as necessary in light of design.

Although a few exemplary embodiments have been shown and described, it will be appreciated by those skilled in the art that changes may be made in these exemplary embodiments without departing from the principles and spirit of the invention, the scope of which is defined in the appended claims and their equivalents.

## Claims

1. A semiconductor light emitting device comprising:
a substrate;
an n-type semiconductor layer giving an electron when receiving voltage;
a p-type semiconductor layer giving a hole when receiving voltage;
an active layer provided between the n-type semiconductor layer and the p-type semiconductor layer and comprising a quantum well structure to facilitate coupling between an electron and a hole;
an n-type electrode comprising conductivity for applying voltage to the n-type semiconductor layer;
a p-type electrode comprising conductivity for applying voltage to the p-type semiconductor layer; and
an electric-current diffusion and hole injection layer provided between the p-type semiconductor layer and the p-type electrode and doped with n-type impurities and p-type impurities for diffusing an electric current and injecting a hole between the p-type electrode and the p-type semiconductor layer.

2. The semiconductor light emitting device according to claim 1, wherein the electric-current diffusion and hole injection layer transmits at least a part of light due to coupling between an electron and a hole.

3. The semiconductor light emitting device according to claim 2, wherein the electric-current diffusion and hole injection layer comprises a compound of ZnO.

4. The semiconductor light emitting device according to any one of claims 1 to 3, wherein at least one of the n-type semiconductor layer and the p-type semiconductor layer comprises a GaN-based compound.

5. The semiconductor light emitting device according to claim 4, wherein the electric-current diffusion and hole injection layer is formed by a molecular beam epitaxy (MBE) method.

6. The semiconductor light emitting device according to claim 4, further comprising a buffer layer between the substrate and the n-type semiconductor layer.

7. A semiconductor light emitting device comprising:
a substrate;
an n-type semiconductor layer giving an electron when receiving voltage;
a p-type semiconductor layer giving a hole when receiving voltage;
an active layer provided between the n-type semiconductor layer and the p-type semiconductor layer and comprising a quantum well structure to facilitate coupling between an electron and a hole;
an n-type electrode comprising conductivity for applying voltage to the n-type semiconductor layer;
a p-type electrode comprising conductivity for applying voltage to the p-type semiconductor layer; and
an electric-current diffusion and hole injection layer provided between the n-type electrode and the n-type semiconductor layer and doped with n-type impurities and p-type impurities for diffusing an electric current and injecting a hole between the n-type electrode and the n-type semiconductor layer.
